# EUROPÄISCHE PATENTSCHRIFT

(11) **EP 2 324 535 B1**
(45) Veröffentlichungstag und Bekanntmachung des Hinweises auf die Patenterteilung: **29.10.2014**
(21) Anmeldenummer: 09768046.6
(22) Anmeldetag: 08.12.2009
(51) Int. Cl.: H01R 11/28, H01R 13/66, G01R 1/20

(54) **BATTERIEMESSKLEMME**
BATTERY MEASURING TERMINAL
BORNE DE MESURE POUR BATTERIE

(30) Priorität: 08.12.2008 DE 102008060668
(43) Veröffentlichungstag der Anmeldung: 25.05.2011
(73) Patentinhaber: Auto-Kabel Management GmbH, 79688 Hausen i.W. (DE)
(72) Erfinder: NENTWIG, Dominik, 41065 Mönchengladbach (DE); GRONWALD, Frank, 50181 Bedburg (DE); LIETZ, Franz-Josef, 46049 Oberhausen-Lirich (DE)
(74) Vertreter: Cohausz & Florack
(86) Internationale Anmeldenummer: PCT/EP2009/066596
(87) Internationale Veröffentlichungsnummer: WO 2010/066713

(56) Entgegenhaltungen:
- DE-A1-102007 018 669
- DE-U1- 20 318 266
- GB-A- 2 441 211
- US-A1- 2008 194 152

## Beschreibung

Der Gegenstand betrifft eine Batteriemessklemme mit einer Batteriepolklemme, einem elektrisch mit der Batteriepolklemme verbundenen Messwiderstand, einer zumindest die Spannung über den Messwiderstand auswertenden Auswertungsschaltung, wobei die Auswertungsschaltung über zumindest zwei Messkontakte mit dem Messwiderstand elektrisch verbunden ist und zumindest zwei Datenleitungen an der Auswertungsschaltung angeordnet sind. Darüber hinaus betrifft der Gegenstand ein Verfahren zur Herstellung einer solchen Batteriemessklemme.

Batteriemessklemmen werden im Automobilbau durch die steigende Anzahl an Komfortverbrauchern in modernen Kraftfahrzeugen immer bedeutsamer. Durch die steigende Anzahl an Komfortverbrauchern steigt auch der Energieverbrauch in Ruhezeiten des Fahrzeugs. Die Batterie muss auch in Ruhezeiten des Fahrzeugs die Komfortverbraucher mit Energie versorgen, was zu einer ständigen, wenn auch langsamen Entladung der Batterie führt.

Um einen Start eines Verbrennungsmotors zu ermöglichen, muss zum Startzeitpunkt am Starter ein ausreichend hoher Strom zur Verfügung stehen. Dieser kann nur zur Verfügung gestellt werden, wenn die Batterie ausreichend geladen ist. Kommt es während längerer Ruhezeiten zu einer teilweisen Entladung der Batterie unter einen Mindestladezustand, so kann ein sicheres Starten des Verbrennungsmotors nicht mehr gewährleistet werden.

Um zu verhindern, dass die Batterie unter einen Mindestladezustand entladen wird, werden Batteriemessklemmen verwendet. Die Batteriemessklemmen messen zumindest einen Spannungsabfall über einen Messwiderstand (Shunt). Anhand des Spannungsabfalls kann auf den Stromfluss geschlossen werden. Darüber hinaus können mit geeigneten Auswertungsmitteln die Batterietemperatur als auch andere physikalische Größen der Batterie unmittelbar an der Batteriemessklemme mit Hilfe einer Auswertungsschaltung ausgewertet werden. Die gemessenen Größen können dazu verwendet werden, um auf den Ladezustand der Batterie zu schließen. Insbesondere die Verwendung der Größen Strom, Spannung und Temperatur ermöglicht es, den Ladezustand er Batterie zu erfassen und auszugeben. Anhand einer solchen Auswertung ist es möglich, Komfortverbraucher abzuschalten, ehe die Batterie unter einem Mindestladezustand entladen wird.

Der Einbau der Batteriemessklemmen erfolgt regelmäßig unmittelbar in der Polnische am Batteriepol. Die mit der Batteriemessklemme gemessenen Werte können über eine Datenleitung abgegriffen werden. Durch eine Vielzahl unterschiedlicher Stecksysteme im Automobilbau kommt es jedoch zu Problemen, die vorhandenen Daten mit einer kostengünstigen Lösung dem Bordmanagement des Fahrzeugs zur Verfügung zu stellen. Unterschiedlichste Steckervarianten sind notwendig, um verschiedensten Herstelleranforderungen für eine Datenschnittstelle zu genügen.

Aus der Veröffentlichung GB 2 441 211 A ist eine Batteriemessklemme bekannt, bei der über einen Messwiderstand ein Spannungsabfall abgreifbar ist, um den Ladungszustand einer Batterie zu erfassen. Der ermittelte Messwert ist über einen Datenanschluss abgreifbar.

Aus der Veröffentlichung DE 10 2007 018 669 A1 ist eine Batteriepolklemme mit einem Schutzelement bekannt. Die beschriebene Batteriemessklemme zeichnet sich dadurch aus, dass zum Schutz des Messwiderstandes vor äußeren Einflüssen ein sich zumindest über die Messfläche des Messwiderstands erstreckendes, vom Messwiderstand beabstandetes Schutzelement vorgeschlagen ist, welches kraftschlüssig an einer Isolation des Batterieanschlusskabels befestigt ist.

Aus der Veröffentlichung US 2008/0194152 A1 ist eine Batteriepolklemme bekannt, die zur Erfassung des Ladezustandes der Batterie einen Messwiderstand aufweist. Der Spannungsabfall über den Messwiderstand ist mess- und auswertbar.

Aus der Veröffentlichung DE 203 18 266 U1 ist eine Anordnung bekannt, bei der eine Auswerteschaltung parallel zu einem Messwiderstand angeordnet ist und über federnde Kontaktelemente mit dem Widerstand verbunden ist.

Aus diesem Grunde lag dem Gegenstand die Aufgabe zugrunde, eine Batteriemessklemme zur Verfügung zu stellen, welche flexible einsetzbar und kostengünstig herstellbar ist.

Diese Aufgabe wird gemäß eines Aspekts dadurch gelöst, dass die Datenleitung in einem Verbindungsmittel angeordnet ist, dass ein Datenanschluss mit einem mit dem Verbindungsmittel korrespondierenden Anschlussmittel monolithisch verbunden ist und dass zum elektrischen Kontaktieren des Datenanschlusses mit den Datenleitungen das Anschlussmittel und das Verbindungsmittel zusammengesteckt sind.

Es ist erkannt worden, dass verschiedenartigste Datenanschlüsse in Form von verschiedenartigsten Steckern oder Buchsen mit der gegenständlichen Batteriemessklemme zur Verfügung gestellt werden müssen. Ferner ist jedoch erkannt worden, dass die Bestückung der Herstellungswerkzeuge für die Batteriemessklemme als auch die Ausrichtung der Herstellungswerkzeuge umständlich ist, wenn für jeden Typ eines Datenanschlusses eine unterschiedlichste Maschineneinrichtung erfolgen muss. Aus diesem Grunde wird vorgeschlagen, dass ein Verbindungsmittel in der Batteriemessklemme vorgesehen ist, in dem die Datenleitungen geführt sind.

Ferner ist erkannt worden, dass ein Datenanschluss mit einem Anschlussmittel monolithisch verbunden sein kann, beispielsweise mittels eines Spritzgußverfahrens. Somit ist es möglich, verschiedenartige Stecker und Buchsen als Datenanschlüsse mit den Anschlussmitteln monolithisch zu verbinden.

Um eine Massenfertigung der Batteriemessklemme zu ermöglichen und gleichzeitig eine individuelle Anpassung des Datenanschlusses zu ermöglichen, wird vorgeschlagen, dass die Anschlussmittel mit den Verbindungsmitteln korrespondieren und die Anschlussmittel in die Verbindungsmittel gesteckt werden können. Über die Verbindungsmittel und Anschlussmittel erfolgt eine elektrische Kontaktierung der in der Batteriemessklemme angeordneten Datenleitung mit dem Datenanschluss und den dort vorgesehenen Kontakten.

Gegenständlich ist es somit nun möglich, die Batteriemessklemme mit den Verbindungsmitteln und den Datenleitungen in einem Prozess herzustellen, der unabhängig von der Art und Form (Formfaktor) des Datenanschlusses ist. Abhängig von Herstelleranforderungen wird der Datenanschluss mit den Anschlussmitteln monolithisch verbunden. Über die Anschlussmittel kann der Datenanschluss mit den Verbindungsmitteln verbunden werden und eine elektrische Kontaktierung des Datenanschlusses mit der Datenleitung kann hierüber erfolgen. Dies ermöglicht es, unterschiedlichsten Herstelleranforderungen an verschiedenste Datenanschlüsse wie Stecker und Buchsen zu genügen und gleichzeitig ein kostengünstiges Verfahren für eine Batteriemessklemme zu etablieren.

Nachdem die Batteriemessklemme mit den Verbindungsmitteln hergestellt wurde und der Datenanschluss monolithisch mit den Anschlussmitteln verbunden wurde, kann das Anschlussmittel in die Verbindungsmittel eingesteckt werden und der Datenanschluss mit der Datenleitung elektrisch verbunden werden.

Gemäß eines vorteilhaften Ausführungsbeispiels wird vorgeschlagen, dass der Datenanschluss mit dem Anschlussmittel verspritzt oder vergossen ist. Dabei ist es möglich, den Datenanschluss in eine vorgeformte Spritz und/oder Gussform einzusetzen und zusammen mit dem Anschlussmittel mit einem Material, beispielsweise Styrolpolymere, wie Polystyrol, SAN, ABS, SBS, ASA, MABS und ABS/PA-Blend, sowie Konstruktionswerkstoffe wie PA, PBT, POM, PES und PSU, zu verspritzen oder zu vergießen, beispielsweise mit geeigneten Kunstharzen. Hierbei ist es möglich, dass die Form des Anschlussmittels durch die Gussform vorgegeben ist, so dass das Anschlussmittel zu den Verbindungsmittel passt.

Gemäß eines vorteilhaften Ausführungsbeispiels wird vorgeschlagen, dass der Datenanschluss ein herstellerspezifischer Stecker oder eine herstellerspezifische Buchse ist. Im Markt der Kraftfahrzeugindustrie haben sich verschiedenste Steckertypen für die verschiedensten Hersteller etabliert. Jeder Hersteller verlangt von seinen Zulieferern, elektrische Signale über die von ihm vorgegebenen Stecker bzw. Buchsen abgreifbar zu machen. Mit der gegenständlichen Batteriemessklemme ist es möglich, unterschiedlichste Stecker oder Buchsen in einer kostengünstigen Art und Weise mit der Batteriemessklemme zu verbinden, in dem genormte Verbindungsmittel mit genormten Anschlussmitteln verbunden werden, wobei die Anschlussmittel mit den verschiedensten Steckern oder Buchsen monolithisch verbunden sind.

Gemäß eines vorteilhaften Ausführungsbeispiels wird vorgeschlagen, dass das Verbindungsmittel und das Anschlussmittel ein zueinander korrespondierendes Stecker-, Buchsen-Paar ist. Somit kann das Verbindungsmittel und das Anschlussmittel zusammengesteckt werden.

Gemäß eines vorteilhaften Ausführungsbeispiels wird vorgeschlagen, dass das Verbindungsmittel mit den Anschlussmitteln beim Zusammenstecken kraftschlüssig und/oder formschlüssig verbindbar ist. Beim Zusammenstecken des Verbindungsmittels mit dem Anschlussmittel wird darüber hinaus ein elektrischer Kontakt zwischen den Datenleitungen und den Kontakten innerhalb des Datenanschlusses hergestellt. Um eine gute elektrische Kontaktierung zu ermöglichen, ist eine kraftschlüssige und/oder formschlüssige Verbindung zwischen Anschlussmittel und Verbindungsmittel sinnvoll, da ansonsten Wackelkontakte auftreten könnten.

Neben unterschiedlichsten Anforderungen an die Steckertypen sind auch Kabelführungen innerhalb des Kraftfahrzeugs, insbesondere in der Nähe der Batterie im Motorraum oder Kofferraum herstellerspezifisch. Unterschiedliche Kabelabgängen der Datenleitungen werden von den Herstellern gefordert, um möglichst kurze Signalwege zu ermöglichen und sonstigen Bauraumanforderungen eines Kraftfahrzeugtyps genüge zu tun. Aus diesem Grunde wird vorgeschlagen, dass gemäß eines vorteilhaften Ausführungsbeispiels der Datenanschluss parallel zur Ausbreitungsrichtung des Messwiderstands verläuft. Der Strompfad verläuft vom Batteriepol über die Batteriepolklemme einen Anschlusssteg und den Messwiderstand zu einem elektrischen Abgriff. Parallel zur Ausbreitungsrichtung des elektrischen Stroms über dem Messwiderstand kann der Datenanschluss verlaufen. Der Datenanschluss kann sich somit in Verlängerung des Messwiderstands an der Batteriemessklemme befinden.

Auch ist es möglich, dass der Datenanschluss orthogonal zur Ausbreitungsrichtung des Messwiderstands verläuft. In diesem Fall kann ein Abgriff seitlich des Messwiderstands erfolgen.

Die Batteriemessklemme ist regelmäßig in einer Polnische angeordnet. Eine mögliche Ausgestaltung sieht vor, dass der Datenanschluss in einer Polnische zwischen der Batteriemessklemme und einer Polnischenwand einer Batterie verläuft.

Auch ist es möglich, dass der Datenanschluss parallel zur Aussenkante einer Batterie in einer Polnische der Batterie verläuft.

Gemäß eines vorteilhaften Ausführungsbeispiels wird ebenfalls vorgeschlagen, dass der Datenanschluss senkrecht zur Aussenkante einer Batterie in einer Polnische der Batterie verläuft.

Zur Kontaktierung des Messwiderstands mit der Batteriepolklemme wird vorgeschlagen, dass ein Anschlusssteg in einer Abgangsrichtung an der Batteriepolklemme angeordnet ist. An diesen Anschlusssteg kann der Messwiderstand angeordnet werden. Der Anschlusssteg bildet somit einen elektrischen Kontakt mit der Batteriepolklemme, als auch einen mechanischen Halt für den Messwiderstand. Die Batteriepolklemme mit den Anschlusssteg kann einstückig geschmiedet sein.

Der Anschlusssteg kann ein Flachteil sein. Dies ermöglicht es, die Messeinrichtung samt Messwiderstand und Auswertungsschaltung flachbauend zu gestalten.

Um den Messwiderstand auf dem Anschlusssteg aufbringen zu können, wird vorgeschlagen, dass der Messwiderstand ein Flachteil ist. Der Messwiderstand kann dabei parallel zum Anschlusssteg auf dem Anschlusssteg angeordnet sein.

Der Anschlusssteg erstreckt sich in Abgangsrichtung von der Batteriepolklemme. Senkrecht zu dieser Abgangsrichtung kann der Messwiderstand an dem Anschlusssteg angeordnet sein.

Um den Messwiderstand mit dem Anschlusssteg zu verbinden, wird vorgeschlagen, dass der Anschlusssteg einen aus der Ebene des Flachteils ragenden Verbindungssteg aufweist. Auf diesen Verbindungssteg kann ein Teil des Messwiderstands elektrisch kontaktiert werden.

Um den Messwiderstand mechanisch mit dem Anschlusssteg zu verbinden, als auch eine ausreichend große Messtrecke zur Verfügung zu stellen, wird vorgeschlagen, dass ein Isolationssteg auf der Ebene des Anschlussstegs, aus der der Verbindungssteg ragt, auf der dem Verbindungssteg gegenüberliegenden Seite des Anschlussstegs angeordnet ist. Der Messwiderstand kann dann sowohl auf dem Anschlusssteg als auch auf dem Isolationssteg aufliegen und zwischen Anschlusssteg und Isolationssteg kann eine Messstrecke liegen, zwischen der ein Spannungsabfall über Messkontakte abgreifbar ist. Die Messkontakte können auf dem Messwiderstand angeordnet sein.

Gemäß eines vorteilhaften Ausführungsbeispiels wird vorgeschlagen, dass der Messwiderstand auf dem Verbindungssteg und dem Isolationssteg aufliegt. Dies ermöglicht es zum Einen, den Messwiderstand mit dem Verbindungssteg elektrisch zu kontaktieren und zum Anderen, die Verbindung zwischen Messwiderstand und Anschlusssteg mechanisch stabil zu gestalten.

Um eine verlässliche Messung des Spannungsabfalls zu gewährleisten, wird ein Spannungsabfall über einem Shuntwiderstand gemessen. Aus diesem Grunde wird vorgeschlagen, dass der Messwiderstand aus zwei Leiterteilen und einem dazwischen angeordneten Widerstandsmaterial gebildet ist. Die Leiterteile können beispielsweise zum Einen auf dem Anschlusssteg und zum Anderen auf dem Isolationssteg aufliegen und das Widerstandsmaterial kann frei von Kontakten mit dem Anschusssteg sein, so dass ein Stromfluss hierüber einen definierten Spannungsabfall bewirkt, welcher ausgewertet werden kann.

Um in der Abgangsrichtung des Datenanschlusses frei zu sein, insbesondere um einen Abgang des Datenanschlusses in Richtung des Batteriepols einer Batteriepolklemme gewährleisten zu können, wird vorgeschlagen, dass das Verbindungsmittel außerhalb einer in Abgangsrichtung liegenden Projektionsfläche der Batteriepolklemme liegt.

Ein Schutz vor mechanischer Beanspruchung als auch vor Umwelteinflüssen wird dadurch ermöglicht, dass der Anschlusssteg mit dem Messwiderstand in einem Material eingebettet ist und dass die Messkontakte und ein elektrischer Abgriff auf dem Messwiderstand frei von dem Material sind. Insbesondere ist es möglich, den Anschlusssteg und den Messwiderstand in einem Spritz- und/oder Gussverfahren zu umspritzen bzw. in ein Gehäuse einzubetten und mit einem Hartz oder ähnlichem zu vergießen. Die Materialien können die bereits oben genannten sein.

Für eine elektrische Kontaktierung müssen zumindest die Messkontakte frei von dem Material sein. Auch ist es notwendig, dass ein elektrischer Abgriff für die Zuleitung zu elektrischen Verbrauchern frei von dem Material ist, um eine elektrische Kontaktierung zu ermöglichen.

Auch wird vorgeschlagen, dass die Aufnahme mit dem Messwiderstand derart in dem Material eingebettet ist, dass das Verbindungsmittel durch das Material gebildet ist. Das Material kann somit so geformt sein, dass es die Verbindungsmittel bildet.

Um zu verhindern, dass der Datenanschluss mit einem elektrischen Abgriff, der zu den Verbrauchern führt, räumlich in Konkurrenz tritt, wird vorgeschlagen, dass das Verbindungsmittel und der elektrische Abgriff an einander gegenüberliegenden Seiten des Messwiderstandes angeordnet sind. Somit ist sowohl die Abgangsrichtung des elektrischen Abgriffs als auch die Abgangsrichtung des Datenanschlusses frei wählbar und nicht in Konflikt mit der jeweils anderen Abgangsrichtung.

Um die mit Hilfe des Messwiderstands gewonnenen Messwerte auswerten zu können, wird vorgeschlagen, eine Auswertungsschaltung vorzusehen. Diese Auswertungsschaltung muss mit den Messkontakten in elektrischen Kontakt treten. Aus diesem Grunde wird vorgeschlagen, dass das Material im Bereich der Messkontakte eine Aufnahme für die Auswertungsschaltung bildet. Somit kann bereits beim Vergießen und/oder Verspritzen der Messkontakte mit dem Anschlusssteg eine Vertiefung vorgesehen sein, die eine Aufnahme für eine Auswertungsschaltung bildet. In dieser Aufnahme kann die Auswertungsschaltung eingesetzt werden.

Die Auswertungsschaltung ist gemäß eines vorteilhaften Ausführungsbeispiels eine bestückte Platine. Eine besonders platzsparende Montage wird dadurch ermöglicht, dass die bestückte Platine mit der Bestückungsseite den Messkontakten zugewandt ist. Außerdem kann in diesem Fall bei einer Montage die bestückte Platine auf die Messkontakte aufgesetzt werden und gelötet werden, beispielsweise in einem Reflow-Lötverfahren, ohne dass die Bauteile auf der Auswertungsschaltung durch Hitze beschädigt werden.

Um die Auswertungsschaltung vor Umwelteinflüssen zu schützen, wird vorgeschlagen, dass ein Deckel über der Auswertungsschaltung an dem Material stoffschlüssig angeordnet ist. Diese Verbindung kann beispielsweise durch Laser-Kunststoffschweißen erfolgen.

Ein weiterer Gegenstand ist ein Verfahren zur Herstellung einer Batteriemessklemme mit elektrischem Verbinden einer Batteriepolklemme mit einem Messwiderstand, elektrisches Verbinden einer Auswertungsschaltung über zumindest zwei Messkontakte mit dem Messwiderstand, Anordnen von zumindest zwei Datenleitungen an der Auswertungsschaltung, gekennzeichnet durch Anordnen der Datenleitung in einem Verbindungsmittel, monolithisches Verbinden eines Datenanschlusses mit einem mit dem Verbindungsmittel korrespondierenden Anschlussmittel und elektrisches Kontaktieren des Datenanschlusses mit den Datenleitungen durch Zusammenstecken des Anschlussmittels mit dem Verbindungsmittel.

Nachfolgend wird der Gegenstand anhand einer Ausführungsbeispiele zeigenden Zeichnung näher erläutert. In der Zeichnung zeigen:
- Fig. 1: eine Batteriepolklemme mit einem Anschlusssteg;
- Fig. 2: einen Messwiderstand;
- Fig. 3: eine Batteriepolklemme mit einem Messwiderstand;
- Fig. 4: eine Batteriepolklemme mit einem umspritzen Messwiderstand;
- Fig. 5: eine Batteriepolklemme mit einem Verbindungsmittel;
- Fig. 6: ein Anschlussmittel mit einem Datenanschluss;
- Fig. 7: ein weiteres Anschlussmittel mit einem Datenanschluss;
- Fig. 8: eine Batteriemessklemme mit einem Datenanschluss;
- Fig. 9: eine zusammengebaute Batteriemessklemme mit einem Datenanschluss und einem elektrischen Abgang;
- Fig. 10a-d: verschiedene Einbauvarianten von gegenständlichen Batteriemessklemmen;
- Fig. 11: ein Verfahren gemäß eines Ausführungsbeispiels.

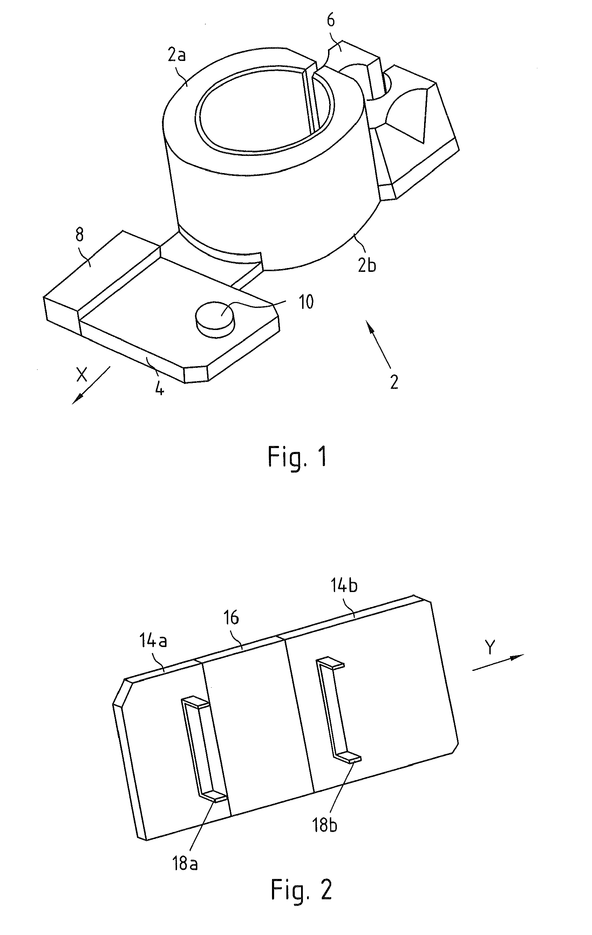

Fig. 1 zeigt eine Batteriepolklemme 2 mit zwei Klemmbacken 2a, 2b und einem Anschlusssteg 4.

Die Klemmbacken 2a, 2b können mittels Verschraubung an der Verschraubvorrichtung 6 zueinander bewegt werden, um mit einem Batteriepol (nicht dargestellt) kraftschlüssig verbunden zu werden.

Die Batteriepolklemme 2 mit dem Anschlusssteg 4 kann einstückig geschmiedet sein. Wie zu erkennen ist, ist der Anschlusssteg 4 in einer Abgangsrichtung X ausgehend von der Batteriepolklemme 2 angeordnet. Ferner ist der Anschlusssteg 4 derart gebildet, dass ein Verbindungssteg 8 aus der Ebene des Anschlussstegs 4 herausragt und auf der dem Verbindungssteg 8 gegenüberliegenden Seite des Anschlussstegs 4 ein Isolationssteg 10 angeordnet ist. Der Isolationssteg 10 kann beispielsweise ein aus einem Kunststoff gebildeter Stopfen sein, der in eine Bohrung in dem Anschlusssteg 4 eingesteckt wird. Auf den Verbindungssteg 8 und den Isolationssteg 10 kann ein Messwiderstand 12, wie er nachfolgend beschrieben wird, aufgesetzt werden.

Fig. 2 zeigt eine Ansicht eines Messwiderstands 12 mit einem ersten Leiterteil 14a und einem zweiten Leiterteil 14b und einem zwischen den Leiterteilen 14 angeordneten Widerstandsmaterial 16. Die Leiterteile 14 können beispielsweise aus Kupfer oder anderen leitenden Nichteisenmetallen oder Legierungen davon gebildet sein. Das Widerstandsmaterial kann beispielsweise eine Kupfer-Mangan-(Nickel- und/oder Zinn) Legierung sein.

Wie zu erkennen ist, ist der Messwiderstand 12 als Flachteil gebildet. Auf den Leiterteilen 14a, 14b sind Messkontakte 18a, 18b stoffschlüssig angeordnet. Die Messkontakte 18 sind flächig auf den Leiterteilen 14 angeordnet und ragen aus der Ebene des Messwiderstands 12 heraus. Die aus der Ebene des Messwiderstands 12 herausragenden Füße der Messkontakte 18 dienen zum elektrischen Kontaktieren der Messkontakte 18 mit einer Auswertungsschaltung.

In Ausbreitungsrichtung Y des Messwiderstands 12 kann ein Stromfluß verlaufen. Der Strom fließt über den Leiterteil 14a, das Widerstandsmaterial 16 und den Leiterteil 14b. Über dem Widerstandsmaterial 16 fällt eine Spannung entsprechend des Stromes und des Widerstandes des Widerstandsmaterials 16 ab, welche mit Hilfe der Messkontakte 18 abgegriffen und in einer Auswertungsschaltung ausgewertet werden kann.

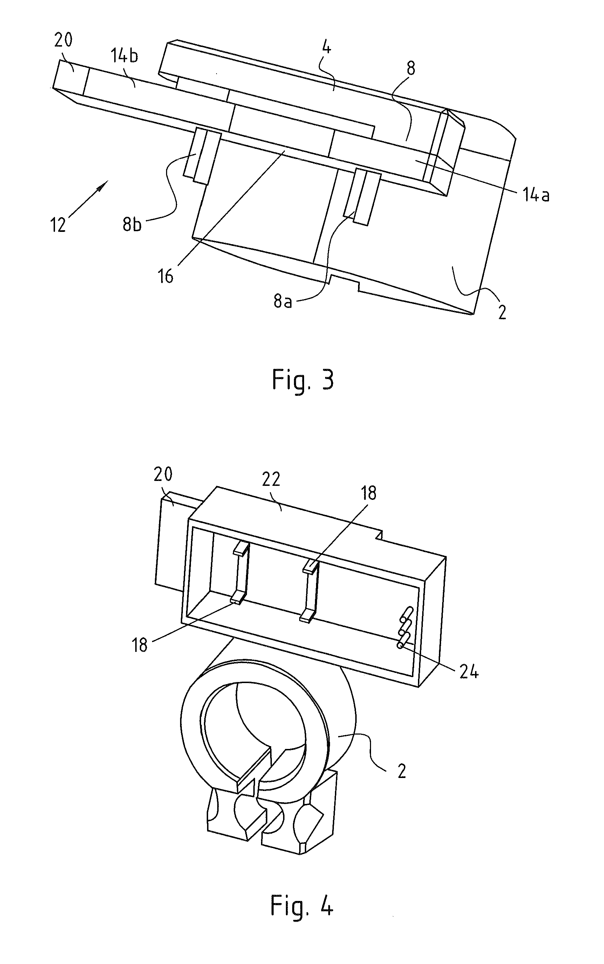

Fig. 3 zeigt eine Batteriepolklemme 2 in einer Ansicht zusammengebaut mit einem Messwiderstand 12. In der Ansicht ist zu erkennen, dass der Messwiderstand 12 einerseits elektrisch kontaktiert auf dem Verbindungssteg 8 aufliegt und andererseits elektrisch gegenüber dem Anschlusssteg 4 auf dem Isolationssteg 10 aufliegt und somit parallel zum Anschlusssteg 4 verläuft. An einem Ende des Messwiderstands 12 kann ein elektrischer Abgriff 20 zum Verbinden der Batterie mit einer Zuleitung zu Verbrauchern gebildet sein.

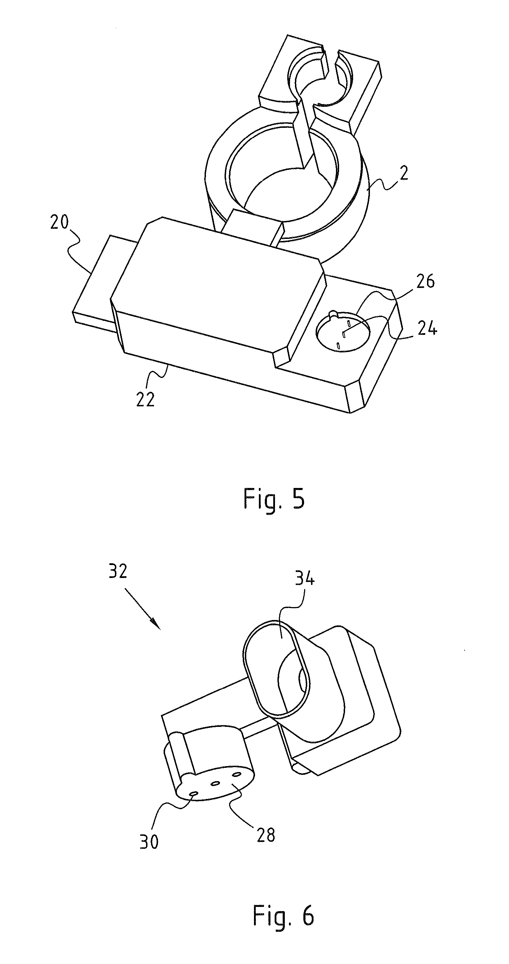

Der Anschlusssteg 4, der Verbindungssteg 8, der Isolationssteg 10, der Messwiderstand 12 und teilweise die Messkontakte 18 können in einem Gehäuse vergossen sein, wie es in Fig. 4 dargestellt ist. Fig. 4 zeigt eine Unteransicht einer Batteriepolklemme 2, bei welcher in einem Gehäuse 22 der Anschlusssteg 4, der Messwiderstand 12, der Verbindungssteg 8, der Isolationssteg 10, die Messkontakte 18 zumindest teilweise und ebenfalls zumindest teilweise der elektrische Abgriff 20 vergossen sind. Zu erkennen ist, dass lediglich die Messkontakte 18 aus dem Vergussmaterial herausragen, ansonsten der Messwiderstand 12 und der Anschlusssteg 4 in dem Gehäuse 22 vergossen sind. Ferner sind elektrische Kontakte 24 im Bereich des Gehäuses 22 zu erkennen. Die elektrischen Kontakte 24 durchstoßen das Gehäuse 22 und sind auf beiden Seiten des Gehäuses 22 elektrisch kontaktierbar. Die elektrische Kontaktierung der elektrischen Kontakte 24 auf der nicht dargestellten Seite des Gehäuses 22 ist in Fig. 5 dargestellt und wird dort näher erläutert.

Die Messkontakte 18 als auch die elektrischen Kontakte 24 können über eine Auswertungsschaltung elektrisch kontaktiert werden. Eine Auswertungsschaltung kann mit ihrer Bestückungsseite in Richtung der elektrischen Kontakte auf die elektrischen Messkontakte 18 als auch die elektrischen Kontakte 24 aufgesetzt werden. Beispielsweise ist es möglich, dass die Messkontakte 18 als auch die elektrischen Kontakte 24 in Bohrungen einer Platine der Auswertungsschaltung eingesteckt werden. Eine elektrische Kontaktierung der Auswertungsschaltung mit den Messkontakten 18 und den elektrischen Kontakten 24 kann beispielsweise von der Oberseite aus durch ein Lötverfahren erfolgen, beispielsweise durch ein Reflow-Löten. Auch ist eine mechanische Kontaktierung der Messkontakte 18 und/oder elektrischen Kontakte 24 z.B. mittels Presskontakten (press-fitt) möglich. Somit sind die Messkontakte 18 als auch die elektrischen Kontakte 24 mit einer Auswertungsschaltung elektrisch kontaktiert. Die Auswertungsschaltung kann zumindest die über die Messkontakte 18 abfallende Spannung auswerten und ein Auswertungsergebnis in Form von Datenimpulsen an die elektrischen Kontakte 24 übergeben.

Fig. 5 zeigt die in Fig. 4 dargestellte Batteriepolklemme 2 von der Oberseite. Zu erkennen ist, dass auf der einen Seite der elektrische Abgriff 20 außerhalb des Gehäuses 22 liegt. Auf der dem elektrischen Abgriff 20 gegenüberliegenden Seite des Gehäuse 22 ist ein Verbindungsmittel 26 in Form einer Buchse zu erkennen. In dem Verbindungsmittel 26 sind die elektrischen Kontakte 24 angeordnet. Das Verbindungsmittel 26 ist eine Vertiefung, in der die elektrischen Kontakten 24 angeordnet sind. Das Verbindungsmittel 26 kann auch ein Stecker oder ein sonstig gearteter elektrischer Anschluss zum Anschließen der elektrischen Kontakte 24 mit einem korrespondierenden Anschlussmittel 28 sein.

Ein solches Anschlussmittel 28 ist beispielsweise in Fig. 6 dargestellt. Fig. 6 zeigt ein als Stecker geformtes Anschlussmittel 28. Das Anschlussmittel 28 ist in seiner äußeren Mantelfläche korrespondierend zu der inneren Mantelfläche des Verbindungsmittels 26. In dem Anschlussmittel 28 sind elektrische Kontakte 30 angeordnet, welche räumlich zu den elektrischen Kontakten 24 in den Verbindungsmitteln 26 korrespondieren. Das Anschlussmittel 28 kann in die Verbindungsmittel 26 eingesteckt werden und darin verrasten. Hierzu kann beispielsweise in den Verbindungsmitteln 26 eine entsprechende Rastnase vorgesehen sein. Beim Einstecken der Anschlussmittel 28 in die Verbindungsmittel 26 erfolgt eine elektrische Kontaktierung der elektrischen Kontakte 24 mit den elektrischen Kontakten 30.

Fig. 6 zeigt ferner, dass das Anschlussmittel 28 einstückig, monolithisch mit einem Datenanschluss 32 mit einem Steckergesicht 34 gebildet ist. Der Datenanschluss 32 kann in Form eines Steckers gebildet sein. Die elektrischen Kontakte 28 werden in dem Gehäuse des Datenanschlusses 32 zu entsprechenden Kontakten innerhalb des Steckergesichts 34 geführt.

Zu erkennen ist, dass die Anschlussmittel 28 mit dem Steckergesicht 34 des Datenanschlusses 32 einstückig geformt sind. Dies ist beispielsweise durch Spritzgießen möglich. Beispielsweise ist es möglich, das Anschlussmittel 28 zusammen mit dem Steckergesicht 34 in einer Spritzgußform miteinander monolithisch zu verbinden, wobei ein flüssiger Kunststoff in die Spritzgußform eingespritzt wird und mit dem Anschlussmittel 28 dem Steckergesichts 34 stoffschlüssig verbunden wird.

Mit Hilfe des Anschlussmittels 28 ist es möglich, eine elektrische Verbindung mit den elektrischen Kontakten 24 in den Verbindungsmitteln 26 herzustellen. Das Anschlussmittel 28 kann genormt sein und zu dem genormten Verbindungsmittel 26 passen. Durch eine monolithische Verbindung des Datenanschlusses 32 mit dem Anschlussmittel 28 ist es möglich, ein genormtes Anschlussmittel 28 mit unterschiedlichsten Steckergesichtern 34 zu versehen, welche dann mit dem genormten Verbindungsmittel 26 verbunden werden können.

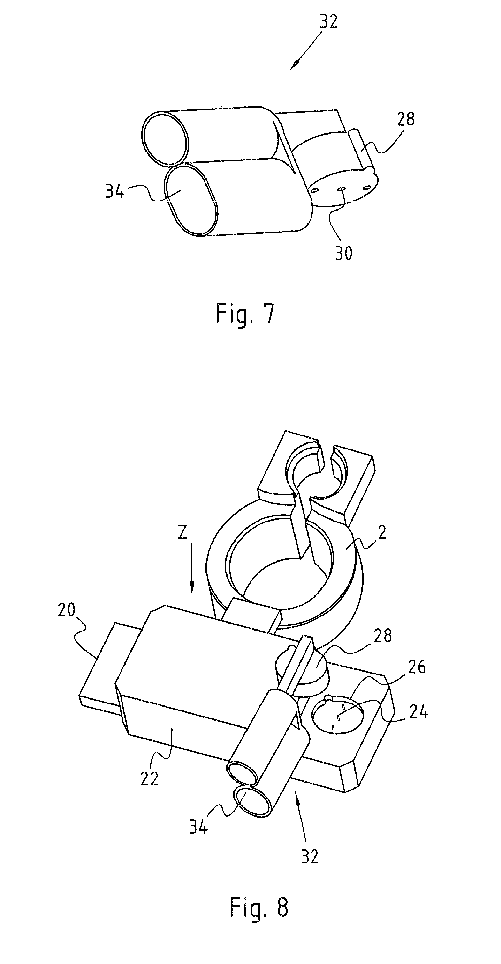

Fig. 7 zeigt eine weitere Ausgestaltung eines Datenanschlusses 32 mit einem Steckergesicht 34 und einem Anschlussmittel 28. Zu erkennen ist, dass das Steckergesicht 34 gemäß Fig. 7 vollkommen unterschiedlichen zu dem Steckergesicht 34 gemäß Fig. 6 ist. Ferner ist jedoch auch zu erkennen, dass die Anschlussmittel 28 in Fig. 6 und Fig. 7 identisch sind. Diese Anschlussmittel passen alle auf die Verbindungsmittel 26 und ermöglichen somit eine Kontaktierung verschiedenster Steckergesichter 34 bzw. Datenanschlüsse 32 mit den genormten Verbindungsmitteln 26.

Fig. 8 zeigt eine Batteriemessklemme mit einer Batteriepolklemme 2, einem elektrischen Abgriff 20, einem Gehäuse 22 sowie Verbindungsmittel 26. Ferner ist ein Anschlussmittel 28 gezeigt, welche in Einschubrichtung Z in die Verbindungsmittel 26 eingesteckt werden kann. Das Anschlussmittel ist mit einem Steckergesicht 34 monolithisch verbunden. Das Steckergesicht 34 ist über den Datenanschluss 32 mit dem Anschlussmittel 28 kontaktiert. Der Abgang des Steckergesichts 34 ist in Abgangsrichtung X.

Auch ist zu erkennen, dass das Verbindungsmittel 26 außerhalb einer Projektionsfläche in Richtung X der Batteriepolklemme 2 liegt, so dass das Steckergesicht 34 sowohl in die gezeigte Richtung, als auch 180° dazu versetzt in Richtung der Batteriepolklemme abgehen kann, ohne dass die Batteriepolklemme 2 den Abgang des Steckergesichts 34 behindert.

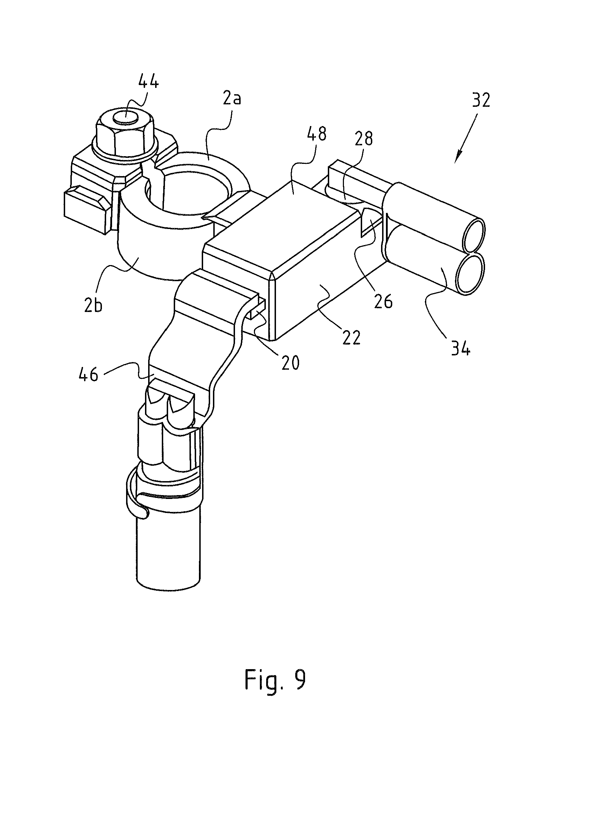

Fig. 9 zeigt eine zusammengebaute Batteriemessklemme, bei der die Batteriepolklemme2 mittels einer Verschraubung 44 verschraubt ist, so dass die Klemmbacken zusammengezogen sind. Das Gehäuse 22 ist zu erkennen. An dem elektrischen Abgriff 20 ist ein Kabelschuh 46 angeordnet, über den ein elektrisches Kabel mit dem elektrischen Abgriff 20 kontaktiert ist. Auch sind ergänzend optional Kontaktbolzen, z.B. als Anschraubpunkte an den Abgriff 20 anordenbar. Eine solche Kontaktierung kann beispielsweise stoffschlüssig durch Schweißen ermöglicht sein.

Auch ist ein Deckel 48 zu erkennen. Der Deckel 48 schließt das Gehäuse 22 derart ab, dass die Auswertungsschaltung abgedichtet ist. Der Deckel 48 kann mittels Laserschweißverfahren mit dem Gehäuse 22 stoffschlüssig verbunden werden. Auch kann der Deckel 48 mittels anderer Schweißverfahren, z.B. Ultraschallschweißen, oder mittels Kleben mit dem Gehäuse 22 verbunden werden.

Das Steckergesicht 34 des Datenanschlusses 32 weist von der Batteriepolklemme 2 fort. Das Anschlussmittel 28 mit dem Datenanschluss 32 ist mit dem Verbindungsmittel 26 kraftschlüssig verbunden. In dem Steckergesicht 34 sind die elektrischen Kontakte, welche über den Datenanschluss 32, die Anschlussmittel 28 und die Verbindungsmittel 26 mit den elektrischen Kontakten 24 verbunden sind.

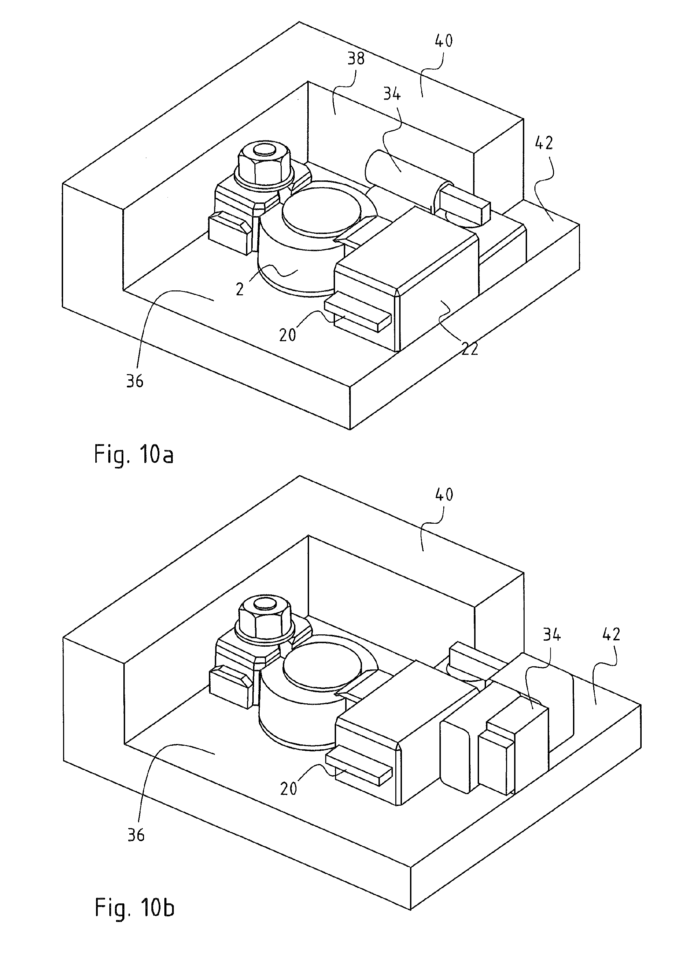

Fig. 10a zeigt ein erstes mögliches Ausführungsbeispiel, bei dem das Steckergesicht 34 des Datenanschlusses 32 in einer Polnische 36 angeordnet ist. Zu erkennen ist, dass das Steckergesicht 34 des Datenanschlusses 32 zwischen dem Batteriepol mit der Batteriepolklemme 2 und einer Wand 38 in der Polnische 36 der Batterie 40 angeordnet ist.

Fig. 10b zeigt ein weiteres Ausführungsbeispiel, bei der das Steckergesicht 34 parallel zum Messwiderstand 12 im Gehäuse 22 verläuft. Der Datenanschluss 32 verläuft parallel zur äußeren Kante 42 der Polnische 36 der Batterie 40.

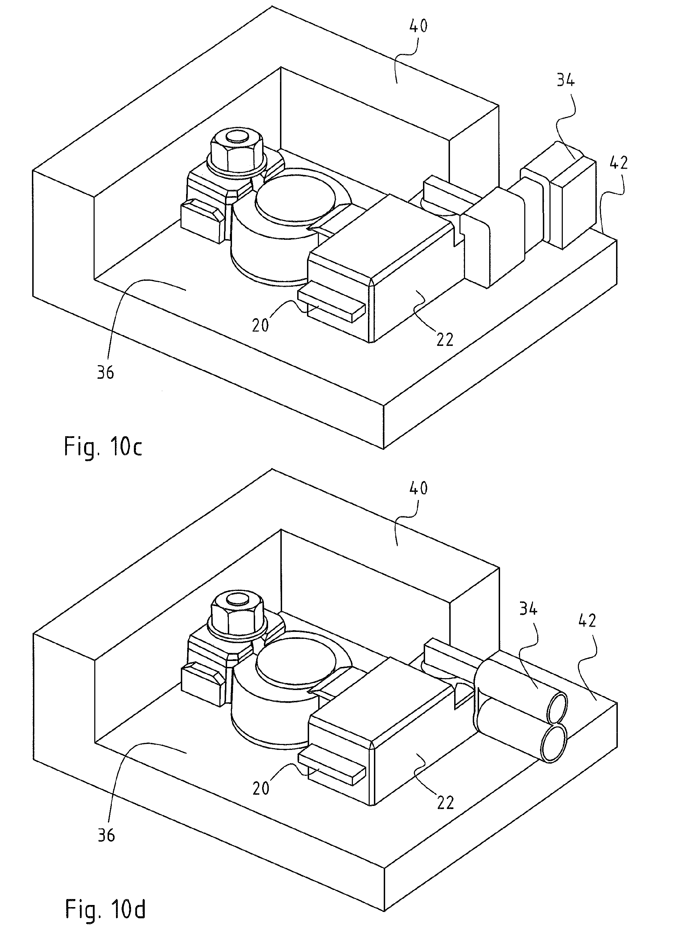

Fig. 10c zeigt eine weitere Ausgestaltung eines Abgangs eines Datenanschlusses 32. Auch hierbei ist das Steckergesicht 34 parallel zur Außenkante 42 der Batterie 40. Das Steckergesicht 34 zeigt jedoch im Gegensatz zu der Fig. 10b in die dem elektrischen Abgriff 20 entgegengesetzten Richtung.

Fig. 10d zeigt eine weitere Ausgestaltung, bei der das Steckergesicht 34 parallel zur Richtung X, senkrecht zur Außenkante 42 der Batterie 40 angeordnet ist.

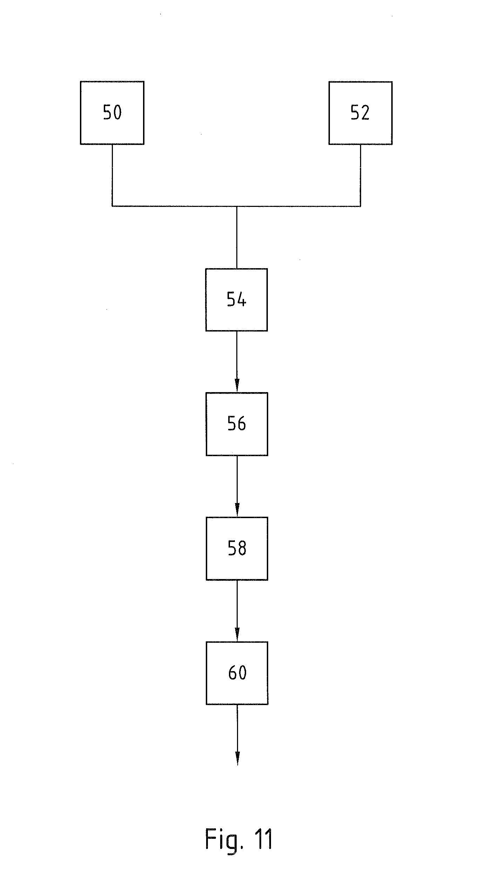

Figur 11 zeigt den Ablauf eines gegenständlichen Verfahrens gemäß eines Ausführungsbeispiels. Zunächst wird eine Batterieklemme 2 gemäß der Figur 1 geschmiedet (50). Parallel dazu kann ein Messwiderstand 12 mit Messkontakten 18 hergestellt werden (52). Die Batterieklemme 2 und der Messwiderstand 12 werden danach wie in Figur 3 gezeigt, miteinander verbunden (54). Hierbei kann ein erster Leiterteil 14a mit dem Verbindungssteg 8 stoffschlüssig, beispielsweise durch Löten, verbunden werden. Ein zweiter Leiterteil kann auf dem Isolationssteg 10 aufliegen. Anschließend wird die der Anschlusssteg 4, der Messwiderstand 12 und die Kontakte 24 in einem Gehäuse 22 vergossen (56). Dies kann so geschehen, dass eine Aufnahme in dem Gehäuse zur Aufnahme einer Auswertungsschaltung verbleibt. In der Aufnahme befinden sich elektrisch durch die Auswertungsschaltung kontaktierbar die Messkontakte 18 sowie die Kontakte 24.

Beim Gießen (56) des Gehäuses kann dieses so geformt werden, dass auf der der Auswertungsschaltung abgewandten Seite die Kontakte ein dem Verbindungsmittel 26 münden und das Verbindungsmittel 26 als Sackloch zur Aufnahme von Anschlussmittel 28 geformt ist.

Die Anschlussmittel 28 können mit dem Steckergesicht 34 des Datenanschlusses 32 gespritzt (58) werden, so dass das Anschlussmittel 28 mit dem Steckergesicht 34 monolithisch verbunden ist. In dem Steckergesicht können Kontakte angeordnet sein, welche mit Kontakten 30 in dem Anschlussmittel 28 verbunden sind.

Abschließend kann das Anschlussmittel 28 in das Verbindungsmittel 26 gesteckt (60) werden.

Mit Hilfe der gegenständlichen Batteriepolklemme ist es möglich, verschiedenartigste Steckergesichter 34 in einem Datenanschluss 32 über ein genormtes Anschlussmittel 28 mit einem genormten Verbindungsmittel 26 zu kontaktieren. Somit ist eine kostengünstige Herstellung einer Batteriemessklemme möglich, die jedoch flexible an verschiedene Kundenanforderungen hinsichtlich der Datenstecker ist.

## Patentansprüche

1. Batteriemessklemme mit
- einer Batteriepolklemme (2),
- einem elektrisch mit der Batteriepolklemme (2) verbundenen Messwiderstand (12),
- einer zumindest die Spannung über den Messwiderstand (12) auswertenden Auswertungsschaltung,
- wobei die Auswertungsschaltung über zumindest zwei Messkontakte (18) mit dem Messwiderstand (12) elektrisch verbunden ist und zumindest zwei Datenleitungen (24) an der Auswertungsschaltung angeordnet sind,
**dadurch gekennzeichnet,**
- **dass** die Datenleitungen (24) in einem Verbindungsmittel (26) angeordnet sind,
- **dass** ein Datenanschluss (32) mit einem mit dem Verbindungsmittel (26) korrespondierenden Anschlussmittel (28) monolithisch verbunden ist, und
- **dass** zum elektrischen Kontaktieren des Datenanschlusses (32) mit den Datenleitungen (24) das Anschlussmittel (28) und das Verbindungsmittel (26) zusammengesteckt sind.

2. Batteriemessklemme nach Anspruch 1, **dadurch gekennzeichnet, dass** der Datenanschluss (32) mit dem Anschlussmittel (28) verspritzt oder vergossen ist und/oder dass der Datenanschluss (32) ein herstellerspezifischer Stecker (34) oder eine herstellerspezifische Buchse ist.

3. Batteriemessklemme nach einem der vorangehenden Ansprüche, **dadurch gekennzeichnet, dass** das Verbindungsmittel (28) und das Anschlussmittel (18) ein 6zueinander korrespondierendes Buchse-, Stecker-Paar ist und/oder dass das Verbindungsmittel (26) mit dem Anschlussmitteln (28) beim Zusammenstecken kraftschlüssig und/oder formschlüssig verbindbar ist.

4. Batteriemessklemme nach einem der vorangehenden Ansprüche, **dadurch gekennzeichnet, dass** der Datenanschluss (32) parallel zur Ausbreitungsrichtung (4) des Messwiderstands verläuft, oder dass der Datenanschluss (32) orthogonal zur Ausbreitungsrichtung (4) des Messwiderstands verläuft, und/oder dass der Datenanschluss (32) in einer Polnische (36) zwischen der Batteriemessklemme und eine Außenwand (38) einer Batterie (40) verläuft, und/oder dass der Datenanschluss (32) parallel zur Außenkante (42) einer Batterie (40) in einer Polnische (36) der Batterie (40) verläuft, und/oder dass der Datenanschluss (32) senkrecht zur Außenkante (42) einer Batterie (40) in einer Polnische der Batterie verläuft.

5. Batteriemessklemme nach einem der vorangehenden Ansprüche, **dadurch gekennzeichnet, dass** ein Anschlusssteg (4) in einer Abgangsrichtung (X) an der Batteriepolklemme (2) angeordnet ist, und/oder dass der Anschlusssteg (4) ein Flachteil ist, und/oder dass der Anschlusssteg (4) einen aus der Ebene des Flachteils ragenden Verbindungssteg (8) aufweist.

6. Batteriemessklemme nach einem der vorangehenden Ansprüche, **dadurch gekennzeichnet, dass** der Messwiderstand (12) ein Flachteil ist, und/oder dass der Messwiderstand (12) im Wesentlichen orthogonal zu der Abgangsrichtung (x) an dem Anschlusssteg (4) angeordnet ist.

7. Batteriemessklemme nach einem der vorangehenden Ansprüche, **dadurch gekennzeichnet, dass** ein Isolationssteg (10) auf der Ebene des Anschlussstegs (4), aus der der Verbindungssteg (8) ragt, auf der dem Verbindungssteg (8) gegenüberliegenden Seite des Anschlussstegs (4) angeordnet ist.

8. Batteriemessklemme nach einem der vorangehenden Ansprüche, **dadurch gekennzeichnet, dass** der Messwiderstand (12) auf dem Verbindungssteg (8) und dem Isolationssteg (10) aufliegt, und/oder dass der Messwiderstand (12) aus zwei Leiterteilen (14) und einem dazwischen angeordneten Widerstandmaterial (16) gebildet ist.

9. Batteriemessklemme nach einem der vorangehenden Ansprüche, **dadurch gekennzeichnet, dass** ein Leiterteil (14) auf dem Verbindungssteg (8) und ein Leiterteil (14) auf dem Isolationssteg (10) angeordnet ist.

10. Batteriemessklemme nach einem der vorangehenden Ansprüche, **dadurch gekennzeichnet, dass** das Verbindungsmittel (26) außerhalb einer in Abgangsrichtung (X) liegenden Projektionsfläche der Batteriepolklemme (2) liegt.

11. Batteriemessklemme nach einem der vorangehenden Ansprüche, **dadurch gekennzeichnet, dass** der Anschlusssteg (4) mit dem Messwiderstand (12) in einem Material eingebettet ist und dass die Messkontakte (18) und ein elektrischer Abgriff (20) auf dem Messwiderstand (12) frei von dem Material sind, und/oder dass der Anschlusssteg (4) mit dem Messwiderstand (12) derart in einem Material eingebettet ist, dass das Verbindungsmittel (26) durch das Material gebildet ist.

12. Batteriemessklemme nach einem der vorangehenden Ansprüche, **dadurch gekennzeichnet, dass** das Verbindungsmittel (26) und der elektrische Abgriff (20) an einander gegenüberliegenden Seiten des Messwiderstandes (12) angeordnet sind.

13. Batteriemessklemme nach einem der vorangehenden Ansprüche, **dadurch gekennzeichnet, dass** das Material im Bereich der Messkontakte (18) eine Aufnahme für die Auswertungsschaltung bildet.

14. Batteriemessklemme nach einem der vorangehenden Ansprüche, **dadurch gekennzeichnet, dass** ein Deckel über der Auswertungsschaltung an dem Material stoffschlüssig angeordnet ist.

15. Verfahren zur Herstellung einer Batteriemessklemme mit
- elektrisches Verbinden einer Batteriepolklemme mit einem Messwiderstand,
- elektrisches Verbinden einer Auswertungsschaltung über zumindest zwei Messkontakte mit dem Messwiderstand,
- Anordnen von zumindest zwei Datenleitungen an der Auswertungsschaltung,
**gekennzeichnet durch**,
- Anordnen der Datenleitungen in einem Verbindungsmittel,
- monolithisches Verbinden eines Datenanschlusses mit einem mit dem Verbindungsmittel korrespondierenden Anschlussmittel, und
- elektrisches Kontaktieren des Datenanschlusses mit den Datenleitungen **durch** Zusammenstecken des Anschlussmittels mit dem Verbindungsmittel.

## Claims

1. Battery measuring clamp, comprising
- a battery pole clamp (2),
- a measuring resistor (12) electrically connected to the battery pole clamp (2),
- an evaluation circuit which evaluates at least the voltage across the measuring resistor (12),
- wherein the evaluation circuit is electrically connected to the measuring resistor (12) via at least two measuring contacts (18) and at least two data lines (24) are arranged on the evaluation circuit,
**characterised in that**
- the data lines (24) are arranged in a connection means (26),
- a data connector (32) is monolithically connected to a coupling means (28) corresponding to the connection means (26), sand
- the coupling means (28) and the connection means (26) are plugged together in order to electrically contact the data connector (32) to the data lines (24).

2. Battery measuring clamp according to claim 1, **characterised in that** the data connector (32) is injection-moulded or cast with the coupling means (28) and/or that the data connector (32) is a plug (34) specific to a manufacturer or a socket specific to a manufacturer.

3. Battery measuring clamp according to one of the preceding claims,
**characterised in that** the connection means (26) and the coupling means (28) are a socket/plug pair corresponding to one another and/or that the connection means (26) can be connected to the coupling means (28) with a force and/or form fit when they are plugged together.

4. Battery measuring clamp according to one of the preceding claims,
**characterised in that** the data connector (32) runs parallel to the extension direction (4) of the measuring resistor or that the data connector (32) runs orthogonal to the extension direction (4) of the measuring resistor and/or that the data connector (32) runs in a pole recess (36) between the battery measuring clamp and an outer wall (38) of a battery (40) and/or that the data connector (32) runs parallel to the outer edge (42) of a battery (40) in a pole recess (36) of the battery (40) and/or that the data connector (32) runs perpendicular to the outer edge (42) of a battery (40) in a pole recess of the battery.

5. Battery measuring clamp according to one of the preceding claims,
**characterised in that** a coupling bar (4) is arranged in an outlet direction (X) on the battery pole clamp (2) and/or that the coupling bar (4) is a flat part and/or that the coupling bar (4) has a connecting bar (8) protruding from the plane of the flat part.

6. Battery measuring clamp according to one of the preceding claims,
**characterised in that** the measuring resistor (12) is a flat part and/or that the measuring resistor (12) is arranged substantially orthogonal to the outlet direction (x) on the coupling bar (4)

7. Battery measuring clamp according to one of the preceding claims,
**characterised in that** an insulating bar (10) is arranged on the plane of the coupling bar (4), out of which the connecting bar (8) protrudes, on the side of the coupling bar (4) opposite the connecting bar (8).

8. Battery measuring clamp according to one of the preceding claims,
**characterised in that** the measuring resistor (12) bears against the connecting bar (8) and the insulating bar (10) and/or that the measuring resistor (12) is formed of two conductor parts (14) and a resistor material (16) arranged therebetween.

9. Battery measuring clamp according to one of the preceding claims,
**characterised in that** one conductor part (14) is arranged on the connecting bar (8) and one conductor part (14) is arranged on the insulating bar (10).

10. Battery measuring clamp according to one of the preceding claims,
**characterised in that** the connection means (26) lies outside a projection surface of the battery pole clamp (2), said projection surface being located in the outlet direction (X).

11. Battery measuring clamp according to one of the preceding claims,
**characterised in that** the coupling bar (4) is embedded with the measuring resistor (12) in a material, and **in that** the measuring contacts (18) and an electrical tap-off (20) on the measuring resistor (12) are free of the material and/or that the coupling bar (4) is embedded with the measuring resistor (12) in a material in such a way that the connection means (26) is formed by the material.

12. Battery measuring clamp according to one of the preceding claims,
**characterised in that** the connection means (26) and the electrical tap-off (20) are arranged on opposite sides of the measuring resistor (12).

13. Battery measuring clamp according to one of the preceding claims,
**characterised in that** the material in the region of the measuring contacts (18) forms a holder for the evaluation circuit.

14. Battery measuring clamp according to one of the preceding claims,
**characterised in that** a cover is arranged over the evaluation circuit in a manner bonded to the material.

15. Method for producing a battery measuring clamp by
- electrically connecting a battery pole clamp to a measuring resistor,
- electrically connecting an evaluation circuit to the measuring resistor via at least two measuring contacts, and
- arranging at least two data lines on the evaluation circuit,
**characterised by**
- arranging the data lines in a connection means,
- monolithically connecting a data connector to a coupling means corresponding to the connection means, and
- electrically contacting the data connector to the data lines by plugging together the coupling means and the connection means.

## Revendications

1. Borne de mesure pour batterie qui comprend
- une borne polaire de batterie (2),
- une résistance de mesure (12) qui est reliée électriquement à la borne polaire de batterie (2),
- un circuit d'évaluation qui évalue au moins la tension par l'intermédiaire de la résistance de mesure (12),
- sachant que le circuit d'évaluation est relié électriquement à la résistance de mesure (12) par l'intermédiaire d'au moins deux contacts de mesure (18) et que deux lignes de données (24), au moins, sont agencées sur le circuit d'évaluation
**caractérisée en ce que**
- les lignes de données (24) sont agencées dans un moyen de connexion (26),
- un connecteur de données (32) est relié de manière monolithique à un moyen de raccordement (28) correspondant au moyen de connexion (26)
et que
- le moyen de raccordement (28) et le moyen de connexion (26) sont enfichés ensemble pour l'établissement du contact électrique entre le connecteur de données (32) et les lignes de données (24).

2. Borne de mesure pour batterie selon la revendication 1,
**caractérisée en ce que** le connecteur de données (32) est extrudé ou coulé avec le moyen de raccordement (28) et / ou que le connecteur de données (32) est une fiche mâle propre au fabricant (34) ou une fiche femelle propre au fabricant.

3. Borne de mesure pour batterie selon l'une des revendications précédentes,
**caractérisée en ce que** le moyen de raccordement (28) et le moyen de connexion (18) sont une paire fiche femelle - fiche mâle qui correspondent l'une à l'autre et / ou que le moyen de connexion (26) peut être relié au moyen de raccordement (28) par adhérence et / ou par emboîtement lors de l'enfichage.

4. Borne de mesure pour batterie selon l'une des revendications précédentes,
**caractérisée en ce que** le connecteur de données (32) s'étend parallèlement à la direction d'étendue (4) de la résistance de mesure ou que le connecteur de données (32) s'étend orthogonalement par rapport à la direction d'étendue (4) de la résistance de mesure et / ou que le connecteur de données (32) s'étend dans une niche du pôle (36), entre la borne de mesure de batterie et une paroi extérieure (38) d'une batterie (40) et / ou que le connecteur de données (32) s'étend perpendiculairement au bord extérieur (42) d'une batterie (40), dans une niche du pôle (36) de la batterie (40) et / ou que le connecteur de données (32) s'étend perpendiculairement au bord extérieur (42) de la batterie (40), dans une niche du pôle de la batterie.

5. Borne de mesure pour batterie selon l'une des revendications précédentes,
**caractérisée en ce qu'**une patte de raccordement (4) est agencée dans une direction (X), sur la borne polaire de batterie (2), et / ou que la patte de raccordement (4) est une pièce plate et / ou que la patte de raccordement (4) est dotée d'une patte de liaison (8) qui fait saillie au-delà du plan de la pièce plate.

6. Borne de mesure pour batterie selon l'une des revendications précédentes,
**caractérisée en ce que** la résistance de mesure (12) est une pièce plate et / ou que la résistance de mesure (12) est disposée orthogonalement par rapport à la direction de départ (X), sur la patte de raccordement (4).

7. Borne de mesure pour batterie selon l'une des revendications précédentes,
**caractérisée en ce qu'**une patte isolante (10) est disposée sur le côté de la patte de raccordement (4) opposé à la patte de liaison (8), sur le plan de la patte de raccordement (4) au-delà duquel la l'axe de rotation (8) fait saillie.

8. Borne de mesure pour batterie selon l'une des revendications précédentes,
**caractérisée en ce que** la résistance de mesure (12) repose sur la patte de liaison (8) et sur la patte isolante (10) et / ou que la résistance de mesure (12) est composée de deux pièces conductrices (14) et d'une matière de résistance (16) qui est disposée entre celles-ci.

9. Borne de mesure pour batterie selon l'une des revendications précédentes,
**caractérisée en ce que** l'une des pièces conductrices (14) est disposée sur La patte de liaison (8) et l'autre pièce conductrice (14) sur la patte isolante (10).

10. Borne de mesure pour batterie selon l'une des revendications précédentes,
**caractérisée en ce que** le moyen de connexion (26) est placé en dehors d'une surface de projection de la borne polaire de batterie (2) située dans la direction de départ (X).

11. Borne de mesure pour batterie selon l'une des revendications précédentes,
**caractérisée en ce que** la patte de raccordement (4) est noyée avec la résistance de mesure (12) dans une matière et que les contacts de mesure (18) et une prise électrique (20), sur la résistance de mesure (12), sont exempts de ladite matière, et / ou que la patte de raccordement (4) est noyée avec la résistance de mesure (12) dans ladite matière de telle manière que le moyen de connexion (26) soit formé par la matière.

12. Borne de mesure pour batterie selon l'une des revendications précédentes,
**caractérisée en ce que** le moyen de connexion (26) et la prise électrique (20) sont disposés sur des côtés de la résistance de mesure (12) situés à l'opposé l'un de l'autre.

13. Borne de mesure pour batterie selon l'une des revendications précédentes, **caractérisée en ce que**, dans la région des contacts de mesure (18), la matière forme un réceptacle pour le circuit d'évaluation.

14. Borne de mesure pour batterie selon l'une des revendications précédentes,
**caractérisée en ce que**, partant de la matière, un couvercle est formé par fusion de matière au-dessus du circuit d'évaluation.

15. Procédé de fabrication d'une borne de mesure de batterie avec
- connexion électrique entre une borne polaire de batterie et une résistance de mesure,
- connexion électrique entre un circuit d'évaluation et la résistance de mesure par l'intermédiaire d'au moins deux contacts de mesure,
- agencement d'au moins deux lignes de données sur le circuit d'évaluation,
**caractérisé par**
- l'agencement des lignes de données dans un moyen de connexion,
- la liaison monolithique entre un connecteur de données et un moyen de raccordement correspondant au moyen de connexion, et
- l'établissement du contact entre le connecteur de données et les lignes de données per enfichage du moyen de raccordement et du moyen de connexion l'un dans l'autre.
